(19) Europäisches Patentamt / European Patent Office / Office européen des brevets

(11) **EP 2 622 385 B1**

(12) **FASCICULE DE BREVET EUROPEEN**

(45) Date de publication et mention
de la délivrance du brevet:
**04.05.2022 Bulletin 2022/18**

(21) Numéro de dépôt: **11773498.8**

(22) Date de dépôt: **14.09.2011**

(51) Classification Internationale des Brevets (IPC):
*G01V 99/00* *(2009.01)*

(52) Classification Coopérative des Brevets (CPC):
**G01V 99/00;** G01V 2210/661

(86) Numéro de dépôt international:
**PCT/FR2011/052099**

(87) Numéro de publication internationale:
**WO 2012/045936 (12.04.2012 Gazette 2012/15)**

(54) **SIMULATION DE KARSTIFICATION**

VERKARSTUNGSSIMULATION

KARSTIFICATION SIMULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2010 FR 1057750**

(43) Date de publication de la demande:
**07.08.2013 Bulletin 2013/32**

(73) Titulaire: **TOTAL SE**
**92400 Courbevoie (FR)**

(72) Inventeurs:
• **MASSONNAT, Gérard**
**F-64000 Pau (FR)**
• **MORANDINI, Francis**
**F-64000 Pau (FR)**

(74) Mandataire: **Plasseraud IP**
**66, rue de la Chaussée d'Antin**
**75440 Paris Cedex 09 (FR)**

(56) Documents cités:
• **O JAQUET: "Stochastic discrete model of karstic networks", ADVANCES IN WATER RESOURCES, vol. 27, no. 7, 1 juillet 2004 (2004-07-01), pages 751-760, XP055002121, ISSN: 0309-1708, DOI: 10.1016/j.advwatres.2004.03.007 cité dans la demande**
• **MARIA P PAPADOPOULOU ET AL: "Terrain Discontinuity Effects in the Regional Flow of a Complex Karstified Aquifer", ENVIRONMENTAL MODELING & ASSESSMENT, KLUWER ACADEMIC PUBLISHERS, DO, vol. 15, no. 5, 27 octobre 2009 (2009-10-27), pages 319-328, XP019817818, ISSN: 1573-2967**
• **ANWAR, S ET AL: "Lattice Boltzmann simulation of solute transport in heterogenous porous media with conduits to estimate macroscopic continuous time random walk model parameters", PROGRESS IN COMPUTATIONAL FLUID DYNAMICS, AN INTERNATIONAL JOURNAL 2008, vol. 8, no. 1/2/3/4, 31 mars 2008 (2008-03-31), pages 213-221, XP008139272, DOI: 10.1504/PCFD.2008.018092**
• **S PEREA-REEVES: "A lattice-gas study of dispersion in alveolated channels", CHEMICAL ENGINEERING SCIENCE, vol. 52, no. 19, 1 octobre 1997 (1997-10-01), pages 3277-3286, XP055002123, ISSN: 0009-2509, DOI: 10.1016/S0009-2509(97)00155-3**

## Description

L'invention se rapporte au domaine de la simulation de processus géologiques pour l'étude du sous-sol. On s'intéresse particulièrement aux phénomènes de karstification dans une zone karstique.

On désigne par karstification d'une roche le phénomène suivant lequel cette roche est façonnée par dissolution de carbonates dans de l'eau. L'eau s'infiltre par des interstices de la roche, par exemple des pores ou des fractures, et cette infiltration augmente la taille de ces interstices du fait de la dissolution de carbonates de la roche dans l'eau infiltrée. Des fractures et des cavités peuvent ainsi être formées.

L'eau peut typiquement être de l'eau de pluie rendue acide par du dioxyde de carbone de l'atmosphère ou du sol. La provenance de l'eau peut être autre, par exemple des remontées hydrothermales.

La roche peut par exemple comprendre du calcaire.

Il est connu de modéliser une zone karstique de façon statique, en utilisant des observations notamment géologiques et sismiques. En cas de forage d'un puits, des données mesurées via le puits, dite données puits, peuvent être utilisées pour ajuster a posteriori le modèle de la zone karstique. Toutefois, cette approche traditionnelle est limitée en ce qu'elle ne reproduit pas de façon dynamique les processus géologiques et hydrologiques conduisant à la formation du karst, et en ce que l'ajustement du modèle aux données puits peut être relativement complexe et parfois instable.

L'article de O.Jaquet et al., « Stochastic discrète model of karstic networks », Advances in Water Resources 27 (2004), 751-760, décrit un procédé de simulation de phénomènes de karstification basé sur une approche stochastique. Une zone karstique est modélisée comme un réseau de conduits correspondant à des fractures plus ou moins larges selon le diamètre du conduit. Des particules correspondant à des gouttes d'eau sont introduites, et leur déplacement sur le réseau est soumis à des lois de type « marche au hasard ».

Il existe un besoin pour améliorer la qualité de la simulation.

Selon un premier aspect, l'invention a pour objet un procédé de simulation de phénomènes de karstification dans une zone karstique, selon la revendication 1.

Les particules peuvent correspondre à de l'eau infiltrant les interstices de la roche.

Avec une telle approche gaz sur réseau, le type de modèle géologique adopté détermine en partie la qualité de la simulation.

Le modèle géologique représente au moins deux milieux, l'un correspondant à un écoulement d'eau dans la roche même, via des pores, et l'autre correspondant à un écoulement d'eau à travers des discontinuités modélisables par des conduits par exemple. Le modèle géologique intègre à la fois des contraintes hydrauliques et géologiques, de sorte que la simulation repose sur une modélisation de meilleure qualité et plus réaliste que dans l'art antérieur.

En outre, cette simulation peut prendre en compte à l'étape c/ le fait que l'infiltration d'eau augmente la taille des interstices.

Bien entendu, on peut prévoir un troisième milieu ou davantage décrit(s) par d'autres paramètres.

Avantageusement, lors de l'étape b/ est en outre pris en compte un gradient hydraulique préétabli, fonction de la zone dans laquelle le déplacement est effectué. Par exemple, si le déplacement envisagé a lieu dans une zone de remontées hydrothermales, le gradient hydraulique peut être dirigé vers le ciel.

L'invention n'est en rien limitée par la prise en compte du gradient hydraulique.

Dans l'invention, lors de l'étape b/, pour au moins un déplacement dans le premier milieu, on estime une valeur de perméabilité équivalente à partir des valeurs de paramètre géologique des mailles comportant une arête correspondant à ce déplacement, par exemple en effectuant une moyenne de ces valeurs.

Ainsi, on peut passer d'une description volumique du premier milieu à une caractérisation des déplacements envisagés.

L'invention n'est bien entendu pas limitée à cette caractéristique. On peut par exemple prévoir de choisir un paramètre équivalent égal à un paramètre géologique de l'une des mailles comportant une arête correspondant à ce déplacement.

Avantageusement, lors de l'étape b/, pour au moins un déplacement dans le deuxième milieu, on estime une valeur de paramètre équivalent à partir de la valeur de paramètre d'arête correspondant à ce déplacement.

Cette valeur de paramètre équivalent peut permettre d'évaluer une probabilité de déplacement.

Ainsi, bien que les descriptions du premier et du deuxième milieu soient relativement différentes, les probabilités de déplacement dans le premier et deuxième milieu peuvent obéir à des lois relativement similaires, dans la mesure où ces probabilités dans les deux cas dépendent de paramètres équivalents.

Bien entendu, l'invention n'est pas limitée par une estimation de valeurs de paramètre équivalent. On peut prévoir que les probabilités de déplacement dans le premier et dans le deuxième milieu obéissent à des lois relativement différentes.

On peut prévoir que les déplacements simulés soient advectifs et/ou dispersifs, même si l'invention n'est bien entendu pas limitée par le type des déplacements envisagés.

On peut aussi prévoir d'offrir la possibilité, lors de l'étape b/, de prendre en compte les valeurs décrivant l'un seulement des premier et deuxième milieux, ce qui permet de mieux quantifier la sensibilité aux conditions initiales (par exemple un nombre de fractures introduites).

En particulier, il peut être proposé à un utilisateur que lors de la simulation soient prises en compte seulement les valeurs décrivant le premier milieu.

L'invention n'est bien entendu pas limitée à cette option. Avantageusement, des observations de la zone karstique sont effectuées, et ces observations sont utilisées, en particulier pour définir à l'étape a/ le modèle géologique maillé de la zone karstique.

Par exemple, on prélève des carottes à divers endroits de la zone karstique. Ces carottes permettent de fournir des informations sur la zone karstique actuelle, en particulier les emplacements grossiers des diverses couches constituant la zone karstique, et pour chaque couche, le faciès de la couche. Ces informations peuvent être utilisées pour définir le modèle géologique maillé. On part ainsi d'un modèle géologique relativement proche de la zone karstique réelle, ce qui permet d'augmenter la fiabilité des résultats de la simulation.

Bien entendu, l'invention n'est pas limitée par ces observations de la zone karstique. On peut par exemple appliquer le procédé selon un aspect de l'invention à des fins d'étude des phénomènes de karstification, en partant de modèles géologiques délibérément factices.

Avantageusement, le premier milieu est décrit par des valeurs de perméabilité de maille. La perméabilité constitue en effet un paramètre impliqué dans le déplacement des particules d'eau dans la roche.

Le premier milieu peut être décrit par d'autres paramètres, comme par exemple la porosité.

L'invention n'est pas limitée aux maillages formant une grille de type boite à sucre (« sugarbox » en anglais). On peut par exemple prévoir des géométries de maille plus complexes.

Selon un autre aspect, l'invention a pour objet un produit programme d'ordinateur de simulation de phénomènes de karstification dans une zone karstique, Z selon la revendication 8.

Selon encore un autre aspect, l'invention a pour objet un dispositif de simulation de phénomènes de karstification dans une zone karstique , selon la revendication 9. Ce dispositif comporte une mémoire pour stocker un modèle géologique maillé de la zone karstique, le modèle comprenant une description d'un premier milieu décrit par des valeurs d'au moins un paramètre géologique de maille, et d'un deuxième milieu décrit par des valeurs de paramètres d'arête entre deux nœuds du maillage. Des moyens de traitement, par exemple un processeur, permettent de simuler des déplacements stochastiques de particules dans le maillage du modèle géologique, chaque déplacement d'une particule étant probabilisé en prenant en compte la description du milieu dans lequel le déplacement est effectué. Les moyens de traitement permettent en outre de modifier les valeurs des descriptions selon les trajets empruntés par les particules.

Ce dispositif peut par exemple comprendre un ordinateur, une unité centrale d'un ordinateur, un processeur, ou bien encore un calculateur dédié à la simulation de phénomènes de karstification.

D'autres particularités et avantages de la présente invention apparaîtront dans la description ci-après.

La figure 1 montre un exemple de zone karstique.

La figure 2 représente schématiquement un exemple de modèle géologique maillé selon un mode de réalisation de l'invention.

La figure 3 est un graphe de la probabilité de déplacement advectif d'une particule en fonction de la perméabilité équivalente, selon un mode de réalisation de l'invention.

La figure 4 est un organigramme simple d'un procédé exécutable par un dispositif de simulation selon un mode de réalisation de l'invention.

La figure 5 montre un exemple de dispositif de simulation de phénomènes de karstification, selon un mode de réalisation de l'invention.

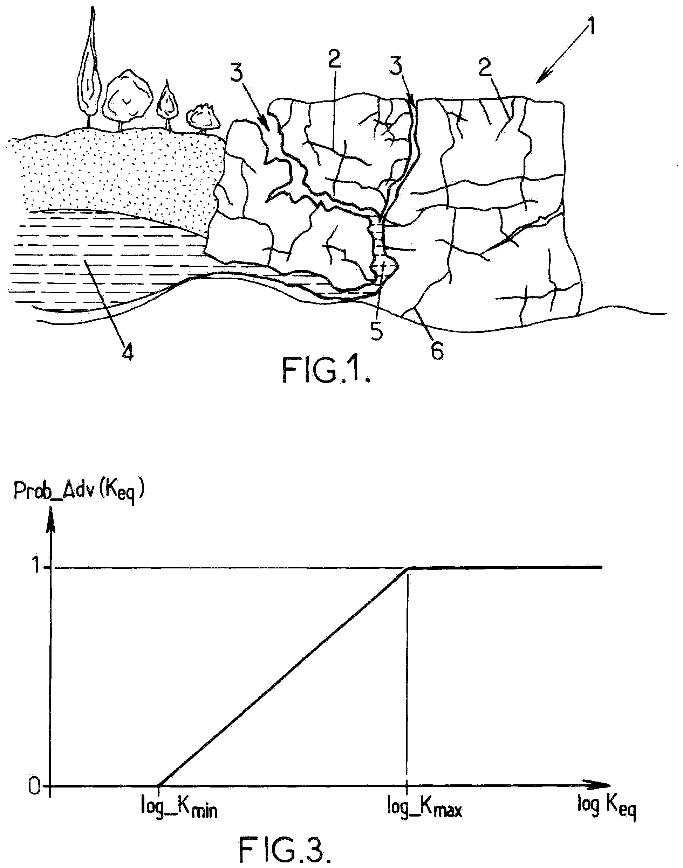

La figure 1 montre un exemple de zone karstique 1. Cette zone 1 comporte des fractures 2, 6, et des cavités 3, 5 dans une roche. Comme la zone 1 est en partie inondée, par exemple du fait de la proximité d'une nappe phréatique 4, les fractures 6 et les cavités 5 peuvent être remplies d'eau.

La roche peut par exemple comprendre du calcaire.

De l'eau de pluie, ou bien encore de l'eau provenant de la nappe phréatique ou de remontées hydrothermales, peut s'infiltrer à travers des interstices, par exemple les pores de la roche, les fractures 2, 6, et/ou les cavités 3, 5. Cette infiltration augmente la taille de ces interstices du fait de la dissolution de carbonates de la roche dans l'eau infiltrée, ce qui peut conduire à la formation de cavités.

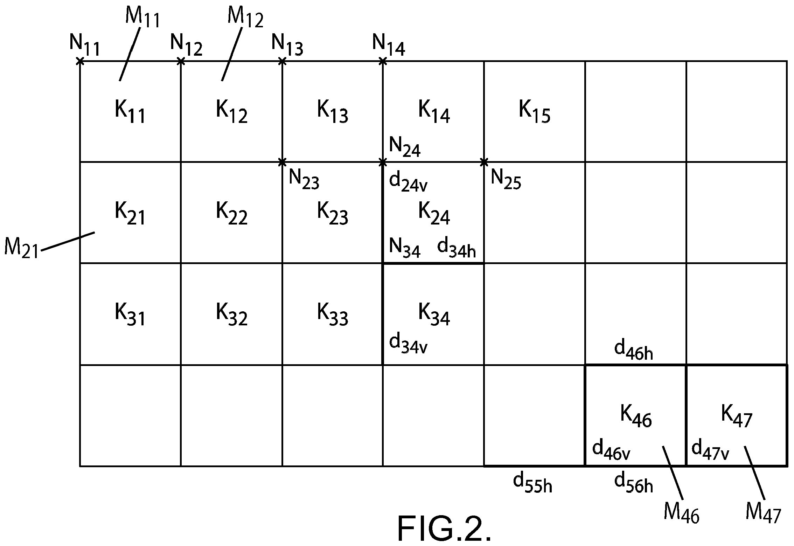

La figure 2 montre schématiquement un exemple de modèle géologique maillé selon un mode de réalisation de l'invention. Ce modèle peut être utilisé pour simuler des phénomènes de karstification, selon une approche « gaz sur réseau ». On simule le déplacement stochastique de particules sur le réseau. Les particules représentent l'eau infiltrée dans la roche. Chaque particule peut par exemple correspondre à une goutte d'eau, à une molécule d'eau, ou autre.

Le modèle géologique maillé peut être à deux dimensions, comme dans l'exemple illustré par la figure 2 pour plus de clarté, ou avantageusement à trois dimensions.

Ce modèle comporte des mailles $M_{11}$, $M_{12}$, $M_{21}$,..., $M_{46}$,....

Dans ce mode de réalisation, on prévoit d'affecter par défaut à chaque maille $M_{ij}$ une valeur de paramètre géologique de maille, ici une valeur de perméabilité $K_{ij}$. Les variables i et j permettent d'indicer les positions des mailles.

Ainsi, à chaque maille $M_{11}$, $M_{12}$ ... correspond une valeur de perméabilité $K_{11}$, $K_{12}$,.... Ces valeurs de perméabilité permettent de décrire un premier milieu.

Le déplacement stochastique d'une particule dans le premier milieu est probabilisé en prenant en compte ces valeurs de perméabilité, de façon à simuler un écoulement dans une roche poreuse, dite également matrice.

Un deuxième milieu est décrit par des valeurs de paramètre d'arête, par exemple des diamètres de conduits $d_{24v}$... entre deux nœuds $N_{24}$, $N_{34}$,....

Le déplacement stochastique d'une particule dans le deuxième milieu est probabilisé en prenant en compte ces valeurs de diamètre de conduits $d_{24v}$..., de façon à simuler un écoulement d'eau à travers des fractures.

Est décrite ci-après un exemple de simulation des déplacements stochastiques sur le réseau.

Les particules peuvent être introduites à un nœud donné, par exemple $N_{11}$, ou bien à plusieurs nœuds. L'introduction de particules peut être effectuée avec une périodicité donnée.

A des fins de simplification, on peut prévoir que les particules n'interagissent pas entre elles, c'est-à-dire que le déplacement d'une particule est indépendant des localisations des autres particules.

Dans ce mode de réalisation, on considère que les particules sont soumises à deux types de déplacements : un déplacement advectif ou systématique, et un déplacement dispersif.

Pour une maille donnée, le déplacement advectif est susceptible d'avoir lieu suivant une direction et un sens donné par un gradient hydraulique correspondant à la zone modélisée, au fait que cette zone soit saturée ou non, ou autre. Par exemple, pour les mailles représentées à la figure 2, le déplacement advectif est susceptible d'avoir lieu suivant la direction et le sens du vecteur de gravité. Pour une cavité saturée, le déplacement advectif est susceptible d'avoir lieu suivant la direction et le sens de l'écoulement. Pour des mailles correspondant à une zone de remontées hydrothermales, le déplacement advectif peut avoir une composante contraire à la force de gravité.

A ce déplacement advectif éventuel s'ajoute le déplacement dispersif, lequel est susceptible d'avoir lieu selon une pluralité de directions.

Lors de la simulation du déplacement d'une particule située sur une maille, on estime une probabilité de déplacement advectif. Un tirage au sort pondéré par cette probabilité estimée est alors effectué, et le déplacement advectif a lieu ou non selon le résultat du tirage au sort.

Cette probabilité est estimée en fonction d'un paramètre de perméabilité équivalente $K_{eq}$.

Pour un déplacement entre deux nœuds du premier milieu, on peut prévoir de calculer une perméabilité équivalente $K_{eq}$ à partir des valeurs de perméabilité des mailles comportant ces deux nœuds. Par exemple, pour un déplacement du nœud $N_{14}$ vers le nœud $N_{24}$, on calcule une perméabilité équivalente à partir des valeurs $K_{13}$, $K_{14}$. Dans le cas d'un réseau tridimensionnel, la perméabilité équivalente serait calculée à partir de quatre valeurs de perméabilité. On passe ainsi d'un modèle volumique à un modèle de grille (« voxcet » en anglais).

La perméabilité équivalente pour un déplacement donné dans le premier milieu peut en particulier être une moyenne, par exemple une moyenne arithmétique ou géométrique, des perméabilités des mailles comportant une arête correspondant à ce déplacement. Pour un déplacement dans le deuxième milieu, c'est-à-dire un déplacement le long d'un conduit, par exemple du nœud $N_{24}$ vers le nœud $N_{34}$, on peut déduire une valeur de perméabilité équivalente $K_{eq}$, à partir du diamètre de conduit d correspondant à ce déplacement, selon par exemple :

$$K_{eq} = 2\log(\frac{1,9}{r})\sqrt{2gd} \ ,$$

r étant la rugosité relative, égale typiquement à 0,2, et g l'accélération de la pesanteur.

La probabilité de déplacement advectif Prob_Adv, dite également « velocity module » en anglais, est estimée à partir des valeurs de perméabilité équivalente, selon :

Pr*ob_Adv*($K_{eq}$)=0 si $K_{eq}$ est inférieur à $K_{min}$,
Pr*ob_Adv*($K_{eq}$)=1 si $K_{eq}$ est supérieur à $K_{max}$ supérieur à $K_{min}$ et

$$\mathrm{Pr}ob\_Adv(K_{eq}) = \frac{\log(K_{eq}) - \log(K_{min})}{\log(K_{max}) - \log(K_{min})}$$

dans les autres cas.

La figure 3 est un graphe de la probabilité de déplacement advectif en fonction de la perméabilité équivalente pour le premier milieu.

Les valeurs $K_{max}$ et $K_{min}$ sont différentes selon que l'on se trouve dans le premier milieu ou le deuxième milieu, que le milieu soit saturé en eau ou non, ou autre.

En particulier, on peut prévoir que les seuils $K_{min}$ et $K_{max}$ pour le premier milieu soient moins rapprochés que les seuils $K_{min}$ et $K_{max}$ pour le deuxième milieu. Un graphe de la probabilité Prob_Adv en fonction du logarithme de K pour le deuxième milieu aurait ainsi la même allure que le graphe de la figure 3, à ceci prés que la pente serait plus raide.

Un tirage au sort pondéré par cette probabilité Prob_Adv est alors effectué, et le déplacement advectif a lieu ou non selon le résultat du tirage au sort.

A cet éventuel déplacement advectif s'ajoute un déplacement dispersif, susceptible d'avoir lieu selon plusieurs directions.

Par exemple, pour revenir à la figure 2, en admettant un déplacement advectif entre les nœuds $N_{14}$ et $N_{24}$, trois possibilités de déplacement dispersif s'offrent à la particule : vers le nœud $N_{23}$, vers le nœud $N_{34}$ ou vers le nœud $N_{25}$. On exclut la possibilité d'un déplacement advectif dans le sens contraire à celui du gradient hydraulique.

Pour chacune de ces possibilités vers un nœud

$N_{ij}$, on estime une probabilité Prob_Disp_ij, selon :

$$\Pr ob\_Disp\_ij(K_{eq}^{i,j}) = \frac{\log(K_{eq}^{i,j})}{\sum\limits_{i,j} \log(K_{eq}^{i,j})}$$

où $K_{eq}^{i,j}$ désigne la perméabilité équivalente pour le déplacement du nœud $N_{24}$ vers le nœud $N_{ij}$, estimée dans le premier milieu à partir des valeurs de perméabilité des mailles ayant une arête correspondant à ce déplacement, et dans le deuxième milieu à partir du diamètre du conduit correspondant à ce déplacement,

$$\sum\limits_{i,j} \log(K_{eq}^{i,j})$$

et où la somme $i,j$ est effectuée sur les diverses possibilités de déplacement dispersif. Pour reprendre l'exemple de la figure 2, cette somme comporte trois termes. Dans un réseau tridimensionnel, cette somme comporterait cinq termes.

En l'occurrence, les valeurs $K_{eq}^{2,3}$ et $K_{eq}^{2,5}$ seraient calculées à partir des valeurs $K_{13}$, $K_{23}$, et $K_{14}$, $K_{24}$, respectivement, tandis que la valeur $K_{eq}^{3,4}$ correspondant à un déplacement le long d'un conduit serait calculée à partir de la valeur $d_{24v}$.

Un tirage au sort pondéré par ces probabilités Prob_Disp_ij est alors effectué, et le déplacement dispersif a lieu dans la direction et le sens donnés par le résultat du tirage au sort. Compte tenu des valeurs usuelles de perméabilité et de diamètres de conduit, le déplacement a des chances relativement élevées d'être effectué dans le deuxième milieu (fracture), c'est-à-dire du nœud $N_{24}$ vers le nœud $N_{34}$.

Ainsi, pour chaque particule, on calcule un déplacement advectif (éventuellement nul) et un déplacement dispersif, et ce de façon répétée sur un nombre de cycles relativement élevé.

Une particule est ainsi capable de passer de la matrice vers la fracture. Dans le sens inverse, on notera que compte tenu des valeurs usuelles de perméabilité et de diamètres de conduit, une particule a relativement peu de chances de passer d'une discontinuité à la matrice. Ces calculs de déplacements stochastiques sont effectués pour chaque particule, et répétés de façon cyclique.

Par exemple, à chaque cycle (« time step » en anglais), $10^9$ particules sont introduites sur le réseau. Le nombre de cycles peut être de l'ordre du million. Le nombre de mailles du réseau peut par exemple être de l'ordre de la centaine de milliers ou du million.

Les valeurs des descriptions du premier et du deuxième milieux sont modifiées selon les trajets empruntés par les particules.

En particulier, on peut prévoir d'affecter à chaque maille une valeur d'un index de karstification IK indicatif du potentiel de dissolution de la roche. Cet index peut avoir des valeurs similaires ou égales pour les mailles d'une zone donnée.

Egalement, on peut prévoir d'affecter à chaque particule une valeur d'un index d'agressivité de particule IA. Typiquement, cet index a une même valeur pour toutes les particules, mais on peut également prévoir des valeurs différentes, par exemple pour rendre compte d'une période de pluies acides.

Ainsi, le passage d'une particule entre deux nœuds du premier milieu modifie les valeurs de perméabilité des mailles possédant une arête correspondant à ce nœud.

Le passage d'une particule dans un conduit du deuxième milieu augmente le diamètre de ce conduit, éventuellement dans la limite d'un diamètre maximal. Par exemple ce diamètre maximal peut être égal à la taille d'un coté de maille. Une cavité de taille supérieure à la taille d'une maille peut ainsi être modélisée par des conduits de diamètre égal au diamètre maximal. Par exemple, les mailles $M_{46}$, $M_{47}$ de la figure 2 peuvent correspondre à une telle cavité.

Dans les deux cas, le volume de matière extrait par le passage de la particule est fonction du produit IKxIA.

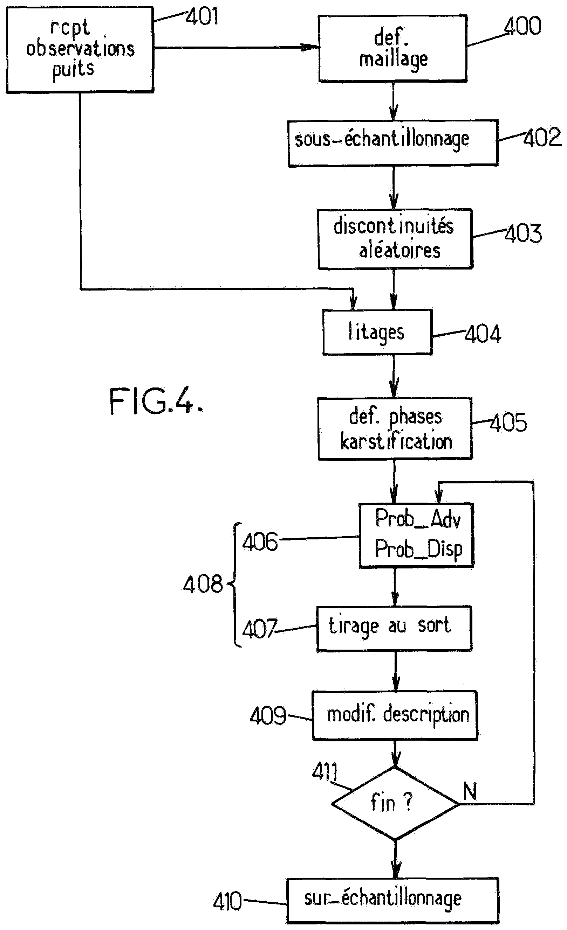

La figure 4 illustre un exemple de procédé de simulation de karstification, selon un mode de réalisation de l'invention.

Un maillage est défini lors d'une étape 400. On peut définir les dimensions associées à chaque maille, par exemple 100x100x5 mètres, et certaines propriétés de maille comme le faciès de la roche correspondant à chaque maille, la porosité, la perméabilité, l'index de karstification IK, ou autre.

Il est possible d'utiliser des observations reçues lors d'une étape 401. Ces observations peuvent par exemple comprendre des carottes, ou bien encore des données d'imagerie fournissant des informations sur la zone karstique actuelle, par exemple des emplacements grossiers de couches géologiques, de failles, de fractures, de barrières imperméables, ou autre.

Les dimensions correspondant à une maille peuvent être variées, par exemple quelques millimètres cubes pour des applications de laboratoire ou bien encore quelques milliers de kilomètres cube.

Un sous-échantillonnage (« rescaling » en anglais) est effectué lors d'une étape 402, pour diminuer le nombre de mailles, de par exemple un facteur $5^3=125$ ou $10^3=1000$, de façon à limiter le temps de simulation.

Lors d'une étape 403, on introduit des discontinuités de type fractures, de manière aléatoire, en utilisant par exemple un moteur de fracturation booléen. Un tel moteur peut être capable de prendre en compte le faciès de la roche, et de générer plusieurs familles de fractures, ces familles étant caractérisées par exemple par des densités de fractures, des géométries de fractures, des orientations de fractures, ou autre.

Lors d'une étape 404, on introduit des discontinuités de type litages ou joints de stratification (« beddings » en anglais). Il est possible d'utiliser des observations reçues lors de l'étape 401.

On peut éventuellement prévoir des étapes non-représentées d'introduction d'autres discontinuités.

Un diamètre de conduit initial est affecté aux arêtes du maillage correspondant à ces discontinuités, lors d'une étape non représentée.

Lors d'une étape 405, différentes phases de karstification sont définies. Par exemple, une phase peut correspondre à une période au cours de laquelle la roche est restée émergée avec un certain gradient hydraulique, puis une autre phase plus tardive à une autre période caractérisée par un autre gradient hydraulique, etc. A chaque phase correspond un ensemble de discontinuités parmi les discontinuités déjà définies, en particulier aux étapes 403 et 404.

Par exemple, on peut avoir défini des discontinuités d'orientation Nord-Sud et des discontinuités d'orientation Est-Ouest lors de l'étape 403. A une première phase peut correspondre la moitié des discontinuités d'orientation Nord-Sud et aucune discontinuité d'orientation Est-Ouest, tandis qu'à une deuxième phase correspond la totalité des discontinuités.

On peut définir pour chaque phase un index d'agressivité de particule IA, un gradient hydraulique, un niveau de zone saturée en eau, les zones d'infiltration et les zones saturées, une orientation de la roche, un vecteur de vitesse, un nombre de cycles affectés à cette phase, les valeurs $K_{min}$ et $K_{max}$ pour chaque milieu, un nombre de particules introduites à chaque cycle, des nœuds d'introduction de particules, ou autre.

A chaque cycle ainsi défini, et pour chaque particule, une simulation de déplacements stochastiques (étape 408) est effectuée. En particulier, on calcule les probabilités Prob_Adv et Prob_Disp (étape 406) et un tirage au sort pondéré par ces probabilités est effectué (étape 407). Le déplacement simulé de la particule est fonction des résultats du tirage au sort.

A chaque cycle, la description est modifiée lors d'une étape 409, selon les déplacements simulés à l'étape 408.

Les étapes 406, 407 et 411 sont effectuées pour chaque particule et pour chaque cycle. On peut en particulier prévoir des boucles pour parcourir les particules et les cycles.

L'étape 409 est effectuée à chaque cycle. On peut prévoir d'effectuer cette étape 409 après chaque calcul de déplacement stochastique pour une particule, ou bien alternativement de calculer les déplacements stochastiques pour l'ensemble des particules avant d'effectuer cette étape 409.

Des étapes de test, représentées par le test 411, permettent de sortir de la boucle. Ces étapes de test peuvent consister à vérifier que tous les cycles définis à l'étape 405 ont été effectués, et que pour chaque cycle, un déplacement a été simulé pour chacune des particules.

Enfin, lors d'une étape 410 de sur-échantillonnage ou remise à l'échelle (« upscaling » en anglais), un modèle avec un maillage du même type que celui défini à l'étape 400 est estimé, à partir de la description obtenue en sortie de boucle.

On peut par exemple utiliser un solveur de pression pour estimer des valeurs de paramètres, par exemple de perméabilité, sur des régions incluant discontinuités et matrice.

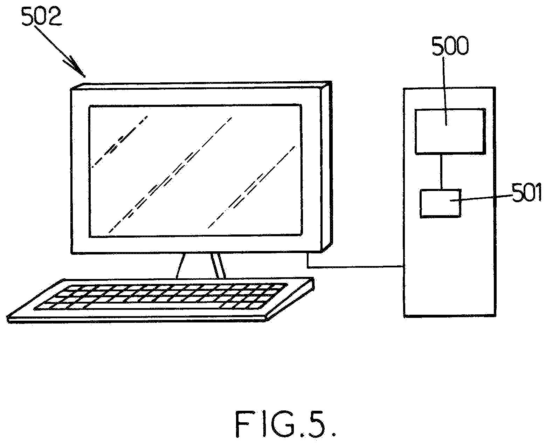

Est représenté sur la figure 5 un exemple de dispositif de simulation 502. Dans ce mode de réalisation, le dispositif comporte un ordinateur 502, comprenant une mémoire 500 pour stocker le modèle géologique maillé, et des moyens de traitement, par exemple un processeur 501 pour effectuer les simulations et modifier le modèle.

**Revendications**

1. Procédé de simulation de phénomènes de karstification dans une zone karstique, comprenant :

   a/ définir (400, 402, 403, 404, 405) un modèle géologique maillé de la zone karstique à partir d'au moins une observation, ladite au moins une observation comprenant des données d'imagerie de la zone karstique, pour modéliser une pluralité de milieux, ladite pluralité comportant un premier milieu décrit par des valeurs d'au moins un paramètre géologique de maille, et un deuxième milieu décrit par des valeurs de paramètres d'arête entre deux nœuds du maillage,
   b/ simuler (408) des déplacements stochastiques de particules dans le maillage du modèle géologique, chaque déplacement d'une particule étant probabilisé en prenant en compte des valeurs décrivant le milieu dans lequel le déplacement est effectué, et
   c/ modifier (409) selon les trajets empruntés par les particules lesdites valeurs décrivant le premier et/ou le deuxième milieu, **caractérisé en ce que**

   lors de l'étape b/, pour au moins un déplacement dans le premier milieu, on estime une valeur de paramètre de perméabilité équivalente ($K_{eq}$) à partir des valeurs d'un paramètre géologique de maille (Kij) des mailles comportant une arête correspondant audit déplacement,
   et dans lequel ledit déplacement est probabilisé en fonction de ladite valeur de paramètre de perméabilité équivalente estimée.

2. Procédé de simulation selon la revendication 1, dans lequel
   lors de l'étape b/, est en outre pris en compte un gradient hydraulique préétabli fonction de la zone

**3.** Procédé de simulation selon l'une des revendications 1 à 2, dans lequel

le paramètre d'arête comprend un diamètre de conduit,

lors de l'étape b/, pour au moins un déplacement dans le deuxième milieu, on estime un paramètre de perméabilité équivalente ($K_{eq}$) à partir de la valeur de diamètre de conduit correspondant audit déplacement,

et dans lequel

ledit déplacement est probabilisé en fonction de ladite valeur de paramètre de perméabilité équivalente estimée.

**4.** Procédé de simulation selon l'une des revendications 1 à 3, dans lequel

les déplacements simulés sont advectifs et/ou dispersifs.

**5.** Procédé de simulation selon l'une des revendications 1 à 4, dans lequel

l'étape c/ fait intervenir une valeur d'un index de karstification (IK) indicatif du potentiel de dissolution de la roche, et une valeur d'un index d'agressivité des particules (IA).

**6.** Procédé de simulation selon l'une des revendications 1 à 5, dans lequel

ledit au moins un paramètre géologique de maille comprend une perméabilité de maille (Kij).

**7.** Procédé de simulation selon l'une des revendications 1 à 6, dans lequel

ledit au moins un paramètre géologique de maille comprend une porosité de maille.

**8.** Produit programme d'ordinateur de simulation de phénomènes de karstification dans une zone karstique, le programme d'ordinateur étant destiné à être stocké dans une mémoire d'une unité centrale, et/ou stocké sur un support mémoire destiné à coopérer avec un lecteur de ladite unité centrale et/ou téléchargé via un réseau de télécommunication, **caractérisé en ce qu'**il comprend des instructions pour:

a/ définir un modèle géologique maillé de la zone karstique à partir d'au moins une observation, ladite au moins une observation comprenant des données d'imagerie de la zone karstique, pour modéliser une pluralité de milieux, ladite pluralité comportant un premier milieu décrit par des valeurs d'au moins un paramètre géologique de maille, et un deuxième milieu décrit par des valeurs de paramètres d'arête entre deux nœuds du maillage,

b/ simuler des déplacements stochastiques de particules dans le maillage du modèle géologique, chaque déplacement d'une particule étant probabilisé en prenant en compte des valeurs décrivant le milieu dans lequel le déplacement est effectué, et

c/ modifier les valeurs décrivant le premier et/ou le deuxième milieu, selon les trajets empruntés par les particules, **caractérisé en ce que**

lors de l'étape b/, pour au moins un déplacement dans le premier milieu, on estime une valeur de paramètre de perméabilité équivalente ($K_{eq}$) à partir des valeurs d'un paramètre géologique de maille (Kij) des mailles comportant une arête correspondant audit déplacement,

et dans lequel ledit déplacement est probabilisé en fonction de ladite valeur de paramètre de perméabilité équivalente estimée.

**9.** Dispositif (502) de simulation de phénomènes de karstification dans une zone karstique, ledit dispositif comportant une mémoire (500) pour stocker un modèle géologique maillé de la zone karstique et des moyens de traitement (501) agencés pour : définir le modèle géologique maillé de la zone karstique à partir d'au moins une observation, ladite au moins une observation comprenant des données d'imagerie de la zone karstique, le modèle comprenant une description d'un premier milieu décrit par des valeurs d'au moins un paramètre géologique de maille, et d'un deuxième milieu décrit par des valeurs de paramètres d'arête entre deux nœuds du maillage,

simuler des déplacements stochastiques de particules dans le maillage du modèle géologique, chaque déplacement d'une particule étant probabilisé en prenant en compte la description du milieu dans lequel le déplacement est effectué, et

modifier l'une et/ou l'autre des descriptions selon les trajets empruntés par les particules, **caractérisé en ce que**

pour au moins un déplacement dans le premier milieu, on estime une valeur de paramètre de perméabilité équivalente ($K_{eq}$) à partir des valeurs d'un paramètre géologique de maille ($K_{ij}$) des mailles comportant une arête correspondant audit déplacement,

et dans lequel ledit déplacement est probabilisé en fonction de ladite valeur de paramètre de perméabilité équivalente estimée.

**Patentansprüche**

**1.** Verfahren zur Simulation von Verkarstungsphänomenen in einer Verkarstungszone, aufweisend:

a/ Definieren (400, 402, 403, 404, 405) eines geologischen Maschennetz-Modells der Verkarstungszone ausgehend von mindestens einer Beobachtung, um mehrere Milieus zu modellieren, wobei die mindestens eine Beobachtung Abbildungsdaten der Verkarstungszone aufweist, wobei die mehreren Milieus ein erstes Milieu, das von Werten mindestens eines geologischen Maschenparameters beschrieben wird, und ein zweites Milieu, das von Parameterwerten einer Kante zwischen zwei Knoten des Maschennetzes beschrieben wird, aufweisen,

b/ Simulieren (408) von stochastischen Bewegungen von Partikeln in dem Maschennetz des geologischen Modells, wobei jede Bewegung eines Partikels unter Berücksichtigung von Werten, die das Milieu beschreiben, in welchem die Bewegung erfolgt, probabilisiert wird, und

c/ Modifizieren (409) der Werte, die das erste und/oder das zweite Milieu beschreiben, gemäß den von den Partikeln benutzten Pfaden,

**dadurch gekennzeichnet, dass**

im Schritt b/ für mindestens eine Bewegung in dem ersten Milieu, ein Parameterwert einer äquivalenten Permeabilität ($K_{eq}$) ausgehend von Werten eines geologischen Maschenparameters ($Kij$) der Maschen, die eine mit der Bewegung assoziierte Kante aufweisen, geschätzt wird,

und in welchem die Bewegung als Funktion des geschätzten Parameterwerts der äquivalenten Permeabilität probabilisiert wird.

2. Simulationsverfahren nach Anspruch 1, in welchem im Schritt b/ ein vorab festgesetzter hydraulischer Gradient je nach Zone, in der die Bewegung erfolgt, berücksichtigt wird.

3. Simulationsverfahren nach einem der Ansprüche 1 bis 2, in welchem

der Kantenparameter einen Leitungsdurchmesser aufweist,

wobei im Schritt b/ für mindestens eine Bewegung in dem zweiten Milieu, ein Parameter einer äquivalenten Permeabilität ($K_{eq}$) ausgehend von dem Wert des mit der Bewegung assoziierten Leitungsdurchmessers geschätzt wird,

und in welchem die Bewegung als Funktion des geschätzten Parameterwerts der äquivalenten Permeabilität probabilisiert wird.

4. Simulationsverfahren nach einem der Ansprüche 1 bis 3, in welchem die simulierten Bewegungen advektiv und/oder dispersiv sind.

5. Simulationsverfahren nach einem der Ansprüche 1 bis 4, in welchem der Schritt c/ einen Wert eines Verkarstungsindexes (IK), der das Auflösungspotential des Gesteins repräsentiert, und einen Wert eines Aggressivitätsindexes der Partikel (IA) mit einbezieht.

6. Simulationsverfahren nach einem der Ansprüche 1 bis 5, in welchem der mindestens eine geologische Maschenparameter eine Maschenpermeabilität ($Kij$) aufweist.

7. Simulationsverfahren nach einem der Ansprüche 1 bis 6, in welchem der mindestens eine geologische Maschenparameter eine Maschenporosität aufweist.

8. Computerprogrammprodukt zur Simulation von Verkarstungsphänomenen in einer Verkarstungszone, wobei das Computerprogramm vorgesehen ist, um in einem Speicher einer Zentraleinheit gespeichert zu werden, und/oder auf einem Speicherträger, der für ein Zusammenwirken mit einem Laufwerk der Zentraleinheit vorgesehen ist, gespeichert zu werden und/oder über ein Telekommunikationsnetzwerk heruntergeladen zu werden, **dadurch gekennzeichnet, dass** es Befehle aufweist um:

a/ ausgehend von mindestens einer Beobachtung, die Abbildungsdaten der Verkarstungszone aufweist, ein geologisches Maschennetz-Modell der Verkarstungszone zu definieren, um mehrere Milieus zu modellieren, wobei die mehreren Milieus ein erstes Milieu, das von Werten mindestens eines geologischen Maschenparameters beschrieben wird, und ein zweites Milieu, das von Parameterwerten einer Kante zwischen zwei Knoten des Maschennetzes beschrieben wird, aufweisen,

b/ stochastische Bewegungen von Partikeln in dem Maschennetz des geologischen Modells zu simulieren, wobei jede Bewegung eines Partikels unter Berücksichtigung von Werten, die das Milieu beschreiben, in welchem die Bewegung erfolgt, probabilisiert wird, und

c/ die Werte, die das erste und/oder das zweite Milieu beschreiben, gemäß den von den Partikeln benutzten Pfaden zu modifizieren,

**dadurch gekennzeichnet, dass**

im Schritt b/ für mindestens eine Bewegung in dem ersten Milieu, ein Parameterwert einer äquivalenten Permeabilität ($K_{eq}$) ausgehend von Werten eines geologischen Maschenparameters ($Kij$) der Maschen, die eine mit der Bewegung assoziierte Kante aufweisen, geschätzt wird,

und in welchem die Bewegung als Funktion des geschätzten Parameterwerts der äquivalenten Permeabilität probabilisiert wird.

9. Vorrichtung (502) zur Simulation von Verkarstungsphänomenen in einer Verkarstungszone, wobei die Vorrichtung einen Speicher (500) zum Speichern eines geologischen Maschennetz-Modells der Verkarstungszone und Verarbeitungseinrichtungen (501) aufweist, die konfiguriert sind, um:

ausgehend von mindestens einer Beobachtung, die Abbildungsdaten der Verkarstungszone aufweist, das geologische Maschennetz-Modell der Verkarstungszone zu definieren, wobei das Modell eine Beschreibung eines ersten Milieus, das von Werten mindestens eines geologischen Maschenparameters beschrieben wird, und eines zweiten Milieus, das von Parameterwerten einer Kante zwischen zwei Knoten des Maschennetzes beschrieben wird, aufweist,

stochastische Bewegungen von Partikeln in dem Maschennetz des geologischen Modells zu simulieren, wobei jede Bewegung eines Partikels unter Berücksichtigung der Beschreibung des Milieus, in welchem die Bewegung erfolgt, probabilisiert wird, und

die eine und/oder die andere der Beschreibungen gemäß den von den Partikeln benutzten Pfaden zu modifizieren,
**dadurch gekennzeichnet, dass**
für mindestens eine Bewegung in dem ersten Milieu, ein Parameterwert einer äquivalenten Permeabilität ($K_{eq}$) ausgehend von Werten eines geologischen Maschenparameters ($Kij$) der Maschen, die eine mit der Bewegung assoziierte Kante aufweisen, geschätzt wird,

und in welchem die Bewegung als Funktion des geschätzten Parameterwerts der äquivalenten Permeabilität probabilisiert wird.

**Claims**

1. A method for simulating karstification phenomena in a karstic region, comprising:

a/ defining (400, 402, 403, 404, 405) a grided geological model of the karstic region from at least one observation, said at least one observation comprising imaging data of the karstic region, in order to model a plurality of environments, said plurality comprising a first environment described by values of at least one geological grid parameter, and a second environment described by values of edge parameters between two nodes of the grid,
b/ simulating (408) stochastic displacements of particles in the grid of the geological model, the probability of each displacement of a particle being calculated by taking into account values describing the environment in which the displacement is carried out, and
c/ modifying (409) said values describing the first and/or the second environment according to the courses taken by the particles, **characterized in that**

in the step b/, for at least one displacement in the first environment, a parameter value ($K_{eq}$) of equivalent permeability is estimated from the values of a geological grid parameter ($K_{ij}$) of the grids comprising an edge corresponding to said displacement, and in which the probability of said displacement is calculated as a function of said estimated parameter value of equivalent permeability.

2. The simulation method as claimed in claim 1, in which
in the step b/, a pre-established hydraulic gradient that is a function of the region in which the displacement is carried out is also taken into account.

3. The simulation method as claimed in one of claims 1 to 2, in which

the edge parameter comprises a pipe diameter, in the step b/, for at least one displacement in the second environment, an parameter of equivalent permeability ($K_{eq}$) is estimated from the pipe diameter value corresponding to said displacement,
and in which
the probability of said displacement is calculated as a function of said estimated parameter value of equivalent permeability.

4. The simulation method as claimed in one of claims 1 to 3, in which
the simulated displacements are advective and/or dispersive.

5. The simulation method as claimed in one of claims 1 to 4, in which
the step c/ involves a value of a karstification index (IK) indicative of the dissolution potential of the rock, and a value of an aggressivity index of the particles (IA) .

6. The simulation method as claimed in one of claims 1 to 5, in which
said at least one geological grid parameter comprises a grid permeability ($Kij$).

7. The simulation method as claimed in one of claims 1 to 6, in which

said at least one geological grid parameter comprises a grid porosity.

8. A computer program product for simulating karstification phenomena in a karstic region, the computer program being intended to be stored in a memory of a central processing unit, and/or stored on a memory medium intended to cooperate with a drive of said central processing unit and/or downloaded via a telecommunication network, **characterized in that** it comprises instructions for:

a/ defining a grided geological model of the karstic region from at least one observation, said at least one observation comprising imaging data of the karstic region, to model a plurality of environments, said plurality comprising a first environment described by values of at least one geological grid parameter, and a second environment described by values of edge parameters between two nodes of the grid,
b/ simulating stochastic displacements of particles in the grid of the geological model, the probability of each displacement of a particle being calculated by taking into account values describing the environment in which the displacement is carried out, and
c/ modifying the values describing the first and/or the second environment, according to the courses taken by the particles, **characterized in that**

in the step b/, for at least one displacement in the first environment, a parameter value ($K_{eq}$) of equivalent permeability is estimated from the values of a geological grid parameter ($K_{ij}$) of the grids comprising an edge corresponding to said displacement, and in which the probability of said displacement is calculated as a function of said estimated parameter value of equivalent permeability.

9. A device (502) for simulating karstification phenomena in a karstic region, said device comprising

a memory (500) for storing a grided geological model of the karstic region, and
processing means (501) arranged to
defining the grided geological model of the karstic region from at least one observation, said at least one observation comprising imaging data of the karstic region, the model comprising a description of a first environment described by values of at least one geological grid parameter, and of a second environment described by values of edge parameters between two nodes of the grid,
simulate stochastic displacements of particles in the grid of the geological model, the probability of each displacement of a particle being calculated by taking into account the description of the environment in which the displacement is carried out, and
modifying one and/or the other of the descriptions according to the courses taken by the particles, **characterized in that**
for at least one displacement in the first environment, a parameter value ($K_{eq}$) of equivalent permeability is estimated from the values of a geological grid parameter ($K_{ij}$) of the grids comprising an edge corresponding to said displacement,
and in which the probability of said displacement is calculated as a function of said estimated parameter value of equivalent permeability.

FIG.1.

FIG.3.

EP 2 622 385 B1

FIG.2.

FIG.4.

FIG.5.

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **O. JAQUET et al.** Stochastic discrète model of karstic networks. *Advances in Water Resources,* 2004, vol. 27, 751-760